# EUROPEAN PATENT SPECIFICATION

(11) **EP 1 184 979 B1**
(45) Date of publication and mention of the grant of the patent: **05.12.2007**
(21) Application number: 01120578.8
(22) Date of filing: 29.08.2001
(51) Int. Cl.: H03H 9/02, H03H 9/05

(54) **Radio frequency module parts including surface elastic wave elements and manufacturing method thereof**
Radiofrequenzmodul mit elastische Oberflächenwellenelemente enhaltenden Bauelementen und Verfahren zur Herstellung derselben
Eléments d'un module radiofréquence comprenant composants à ondes élastiques de surface et procédé pour leur fabrication

(30) Priority: 30.08.2000 JP 2000260206
(43) Date of publication of application: 06.03.2002
(73) Proprietor: TDK Corporation, Chuo-ku, Tokyo (JP)
(72) Inventor: Uchikoba, Fumio, c/o TDK Corporation, Tokyo (JP)
(74) Representative: Grünecker, Kinkeldey, Stockmair & Schwanhäusser Anwaltssozietät

(56) References cited:
- EP-A- 0 794 616
- DE-A- 19 648 308

## Description

The present invention relates to radio frequency module parts including surface acoustic wave elements of flip chip type which is mounted on a ceramic multi-layer substrate, and in particular relates to radio frequency module parts including surface acoustic wave elements, which enable to increase reliability for use, improve element mounting efficiency, reduce height in size of the product, and further increase productivity, and a manufacturing method thereof. A similar part is known e.g. from EP 0 794 616 A2.

Miniaturization of electronic appliances is always required in the market, and also as to parts to be used, reduction of size and weight is required. This requirement is particularly remarkable in the radio frequency appliances represented by mobile telephones. Also, in parts to be used, such requirement is remarkable. With respect to the radio frequency appliances, the electronic parts are mounted with high density, and requirement for reducing size and weight of parts has been complied. Also as to substrates for mounting elements thereon, for coping with miniaturization, a multi-layer substrate having plural conductor layers have mainly been used in place of a conventional substrate having a single-layer conductor.

A ceramic multi-layer substrate is formed in that an insulating layer of the multi-layer substrate is formed with ceramics which is an electrical insulator, and a conductive layer such as silver is formed. In comparison to general resin multi-layer substrate, the ceramic multi-layer substrate shows characteristics such as low loss at radio frequency, good heat conductivity, dimensional high precision and excellent reliability.

The ceramic multi-layer substrate is provided with internal conductors which are coiled or arranged opposite to each other in parallel so that inductance and capacitance may be formed therein. Further, being low in loss and high in dimensional precision, it is possible to form such elements of a high quality factor and of a low tolerance at the interior of the ceramic multi-layer substrate.

These ceramics multi-layer substrates are used as a module in the radio frequency circuit such as a mobile telephone, in that various parts are mounted on the surface to form integrated elements having excellent properties and being small in size.

Since the radio frequency modules have the circuits assembled per each function, in comparison with a conventional technique of mounting discrete components one by one to form circuits, the structure of appliance is simple, reliable and is excellent in property. Further, since the conventional discrete members perform the functions respectively in combination of properties of each member, the design is complicated. However, turning into the module formation, the property specification is determined in each module, so that when designing the appliance, the design is structured and time and labor may be saved.

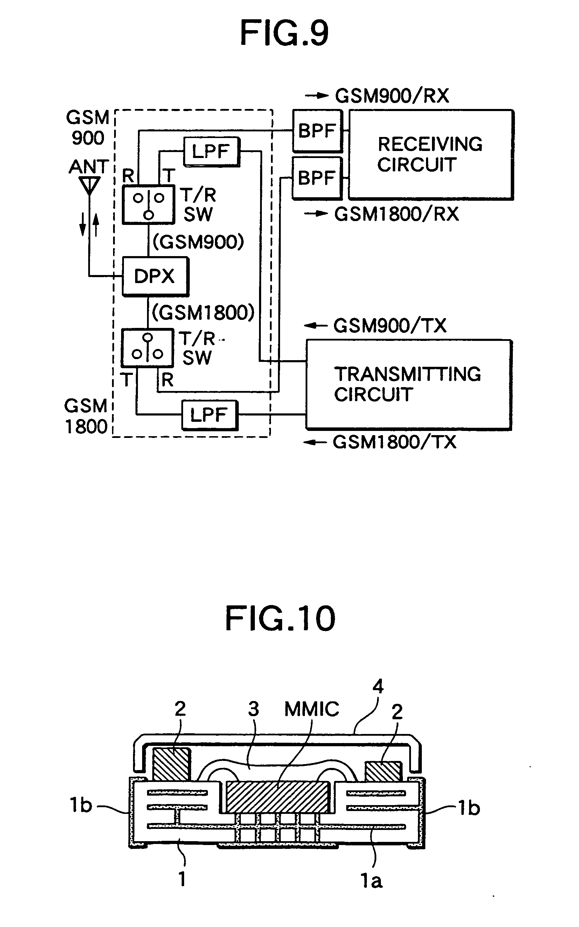

Fig. 9 shows a block diagram of the radio frequency circuit of a mobile telephone of GSM dual band type which is most broadly used in the world. In the same, ANT is an antenna for transmitting and receiving electric waves, DPX is a diplexer (2-frequency filter) as a filter for separating a plurality of frequency, T/R SW is a transmission/receiving switch for switching transmission and receiving, LPF is a low-pass filter for controlling the radio frequency at transmission stage, and BPF is a band-pass filter at receiving stage.

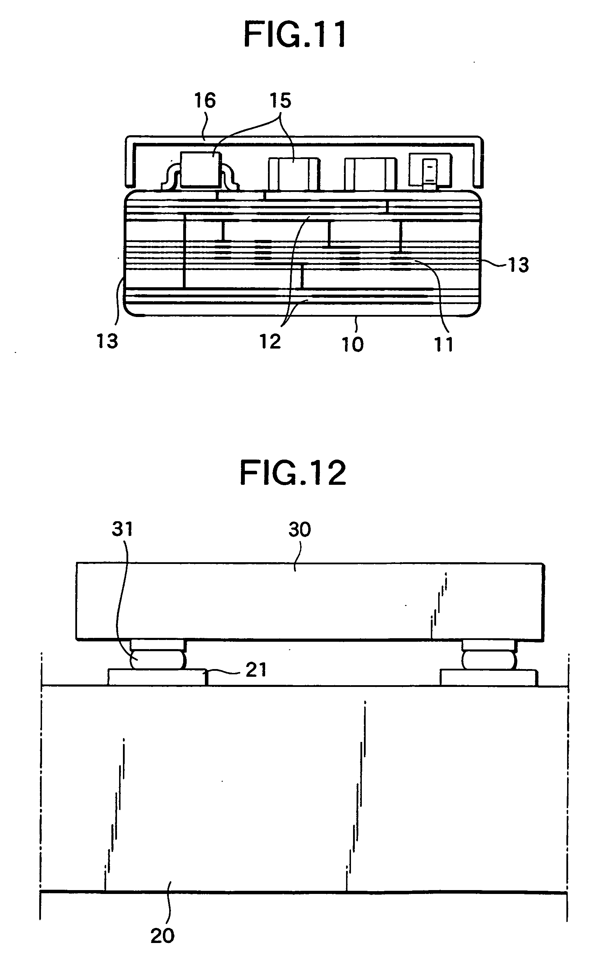

In such circuits of mobile telephones, the module is formed with a certain number of functions by actually mounting elements on the multi-layer substrate, for example, at the power amplifier portion in the transmission based circuit and at the antenna switch portion. Figs. 10 and 11 show the structures of the respective cases.

Fig. 10 shows an example of power amplifier module, where reference numeral 1 designates a dielectric multi-layer substrate having an internal electrode 1a and external electrodes 1b. On the dielectric multi-layer substrate, there are mounted MMIC which is a main portion of power amplifier and chip members 2 of the peripheral circuits. The MMIC is protected by a protection coating 3 and the upper side of the dielectric multi-layer substrate is entirely covered with a shield case 4.

Fig. 11 shows an example of a front-end module including the antenna switch portion, where reference numeral 10 is a ceramic multi-layer substrate having an internal inductance portion 11, capacitor portions 12 and external electrodes 13. Further, on the ceramic multi-layer substrate 10, there are mounted chip members 15 including diodes, resistors and others, and a shield case 16 for entirely covering the upper side of the ceramic multi-layer substrate. However, the front-end module of Fig. 11 does not include the surface acoustic wave element (called as "SAW element" hereafter) or includes a package member even if including the same.

Nowadays, the module formation is realized in a single function such as power amplifier and antenna switch module. If a broader function is formed into the module, further merits of the module will be taken out. It is a matter of course that the module formation including the SAW elements will be important.

The conventional SAW elements have been package members . It is of course possible to form the module by mounting the package members. However, as will be described in connection with the invention, mounting of element chips directly on the substrate enables to realize a product which is miniaturized and reduced in thickness. Further, the production cost will be reduced.

The ceramic multi-layer substrate may have the inductance and capacitance therein and is characterized by the miniaturization thereby, but on the other hand, reduction in height is difficult. Therefore, the generally available module having mounted the package on the substrate will not satisfy the demand for reduction of height, which will further increase in future. Further, the package member occupies a wide area, comparing with an original bare chip. Among the components to be used, the SAW element is one of the tallest components and has the broad occupying area. Under these circumstances, it is demanded that the SAW element is directly mounted to the ceramic multi-layer substrate in any formation without using the package.

On the other hand, as to the production of the SAW element, there are a process of forming the SAW chip and a process of mounting the SAW element to the package and sealing the same. Costs for the respective processes are needed. If the SAW element may be directly mounted to the ceramic multi-layer substrate, the production cost will be reduced because the processes for mounting on the package and sealing may not be needed.

As has been described, regarding the radio frequency module, it is desirable to directly mount the SAW element, as being the chip, to the ceramic multi-layer substrate to which other members are mounted by soldering.

By the way, for realizing the above mentioned, the following problems are present.

(1) It is required to seal by airtight the chip of SAW element.
(2) It is required to realize a structure which is resistible against change in temperature in a supporting manner not influencing to the surface acoustic wave.
(3) It is required to make compatible the soldering process and the mounting process of the SAW element.
(4) It is required to make flat the surface of the module while realizing the reduction of height.
(5) It is required to treat a plurality of ceramic multi-layer substrates in a lump, thereby to increase the production efficiency.

### (1) Regarding the requirement for airtight-sealing the SAW element:

The SAW element is made, for example, by forming a ladder like electrode of aluminum at a precision of sub-micron (µm) order, for example, on a lithium tantalite substrate. The electrode pattern is precisely designed for obtaining important properties including resonance frequency, bandwidth, insertion loss, out-of-band loss. For example, an error of 1 µm will not satisfy the designing specification.

The thus precisely designed element is very likely influenced from an external air. A water content by humidity and adherence of dusts and others give fatal influences to the properties.

In these cases, any measure should be taken for sealing, and in the module targeted by the invention, it is necessary to take a process compatible with miniaturization, reduction of height and simultaneous mounting with the other members.

### (2) Regarding the requirement for supporting the element free of influence to the surface acoustic waves:

In case of mounting the bare chips of a silicon based integrated circuit, the chips may be mounted to the substrate firmly and with entire surface adhered by use of such as an adhesive. However in case of the SAW element, since the resonance property is obtained by presence of the elastic waves at the surface of the element, it is, therefore, impossible to firmly fix the entire surface of the chips to the substrate by use of the adhesive.

In the case of the existing small SAW element, as disclosed for example, in JP-A-10-79638, the element is fixed to a ceramic substrate or a resin substrate by way of a so called flip chip mounting. This is shown in Fig. 12, where reference numeral 20 is a substrate, and 30 is a flip chip as the SAW element. On the substrate 20, there is formed an electrode 21, the surface of which is gold (Au), and the flip chip 30 has a gold stud bump 31 formed on the main surface thereof which is formed with a ladder type electrode for the SAW. The flip chip 30 is mounted (face-down-bonding) by way of gold-to-gold bonding where the main surface formed with the ladder type electrode for the SAW is turned down.

Also in the invention, it seems effective to follow this method for mounting the SAW element. But no problem must occur, even if mounting in combination with other soldering members. Particularly, differently from a single SAW element, in case being combined with other members in a composite module, the ceramic multi-layer substrate becomes thick. In this case, stress applied to the bonding portions is large comparing with a normal package member.

### (3) Regarding the requirement for making compatible the soldering process and the SAW element mounting process:

Generally in the soldering process, a solder paste is printed to the land portions on the substrate surface, and then the elements are placed and heat-treated through a reflow furnace fix the same thereon. In this case, a flux existing in the paste is evaporated to activate an interface relative to the surface electrodes, thereby to secure wetness of the solder.

In case of the invention, the SAW element is mounted as is exposed, and if being in advance mounted without securing the air-tightness, adherence of the flux occurs to affect considerable influences to properties of the SAW element.

Further, the SAW element is generally bonded by the gold-to-gold bump bonding. In the case of the solder bonding, the metal surface on the substrate is a tin- or a solder-film, and these are normally formed by plating.

The method of mounting in combination of the bared SAW elements and the solder-mounting parts has not yet been established as the invention.

### (4) Regarding the requirement for flattening the module surface and reducing the height thereof:

For mounting the electronic members, the method using an automatic mounting machine has been established and broadly employed. The apparatus normally includes a vacuum absorbing nozzle for handling the members, and therefore, the member should have a flat surface which is wider than at least the diameter of the nozzle. According to the prior art method, the surface of the composite module is covered with a metal plate. However, in the invention, the addition of a flattening structure to the airtight structure is contrary to the requirement for reducing the height.

### (5) Regarding the requirement for increasing the production efficiency by treating a plurality of ceramic multi-layer substrates in a lump:

Normally, it is considered that the ceramic multi-layer substrates are individually treated through a process. However, the individual treatment requires much labor and gives no merit for increasing the production efficiency, and in turn will increase the production cost. Thus, it is desired to treat a plurality of pieces of the ceramic multi-layer substrates in a lump.

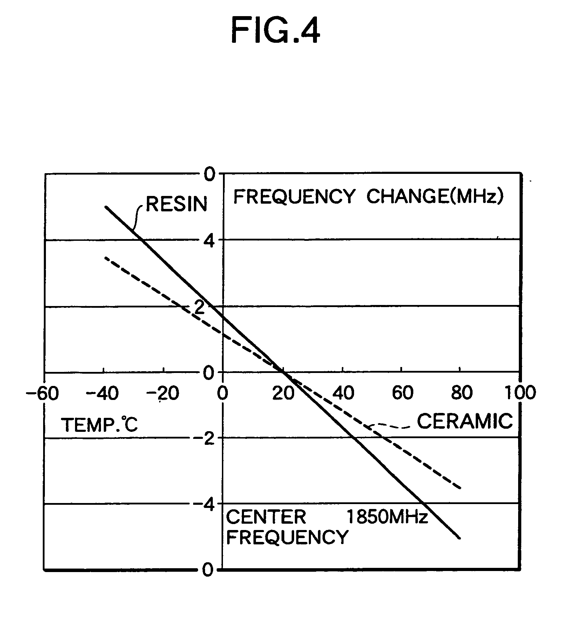

JP-A-6-97315 discloses a preceding example of mounting the SAW element together with other circuit members and sealing the same. According to the preceding example, the SAW element is fixed as is turned up to a resin substrate and is electrically connected by a wire bonding. This is apparently different from the invention which mounts the SAW element to the multi-layer ceramic substrate in the form of flip chip. According to the invention, by way of the flip chip mounting, miniaturization may be realized, and by way of taking the form of flip chip, the influence owing to difference in the heat expansion rate in relation with the substrate may be reduced. JP-A-6-97315 refers to that difference exists in the heat expansion rate between the ceramic substrates, which gives rise to problems. However, in the invention, such influence is extremely little. Particularly, the temperature coefficient of the SAW element and the difference in the heat expansion rate are likely offset, and the temperature property of center frequency of the flip chip in the case of the resin substrate and in the case of the ceramic substrate is better in the ceramic substrate as shown in Fig. 4.

By the way, JP-A-6-97315 seems to disclose the mounting in combination with other passive members, but does not disclose the mounting together with the solder mounting members. Particularly, the solder is used for sealing, but in this case, for avoiding contamination by flux, an instantaneous heating method is employed. In short, it is suggested that the mounting in combination with the solder mounting members is extremely difficult. Depending on the invention, the mounting together with other solder mounting members may be available by taking a cleaning process (cleaning process), and this is simpler, and other various members may be mounted together.

### SUMMARY OF THE INVENTION

Accordingly, in view of the above mentioned points, it is a first object of the invention to provide a radio frequency module part including surface acoustic wave elements and a manufacturing method thereof, enabling to mount an SAW element as a bare chip and mount together with other solder mounting members.

It is a second object of the invention to provide a radio frequency module part including surface acoustic wave elements and a manufacturing method thereof, where the SAW element may be mounted as a bare chip, thereby to secure miniaturization, reduction in height, increase of production efficiency and cost-down.

Other objects and new characteristics of the invention will be apparent in the following description in reference to the modes for carrying out the invention.

The invention is defined in the appended claims.

### BRIEF DESCRIPTION OF THE DRAWINGS

Fig. 1 is a front and cross sectional view of the radio frequency module parts including the surface acoustic wave elements according to the first mode for carrying out the invention;
Figs. 2A to 2G are explanatory views showing the production processes of the first mode;
Fig. 3 is a diagrammatic view of a circuit in the first mode;
Fig. 4 is a diagrammatic view of the ceramic substrate and the resin substrate showing the temperature characteristics of the SAW elements in case;
Figs. 5A to 5E are explanatory views showing the production processes of the second mode for carrying out the invention;
Fig. 6 is a plan view of the resin member to be used for the second mode;
Fig. 7 is a front and cross sectional view of a third mode for carrying out the invention shown;
Fig. 8 is a front and cross sectional view showing an example of the module mounted thereon with the package member of the conventional SAW elements;
Fig. 9 is a block diagrammatic view of the radio frequency circuit for GSM dual band type mobile telephone;
Fig. 10 is a front and cross sectional view of the power amplifier module;
Fig. 11 is a front and cross sectional view showing the front end module including the antenna switch portion; and
Fig. 12 is a front and cross sectional view of showing an example of face-down-bonding (flip chips mounted) by way of gold-to-gold bonding the SAW.

Explanation will be made to the mode for carrying out the radio frequency module parts including the surface acoustic wave elements and the manufacturing method thereof depending on the invention with reference to the attached drawings.

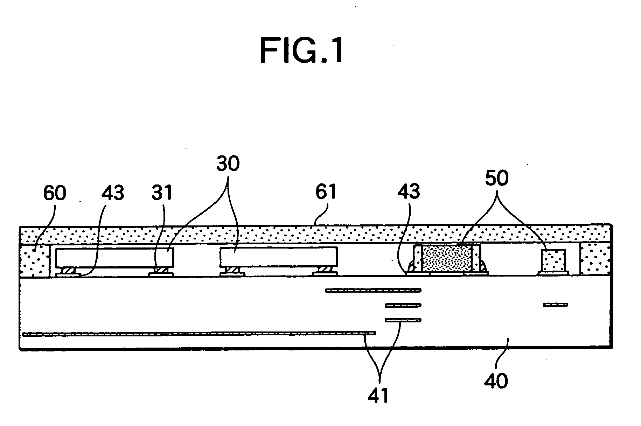

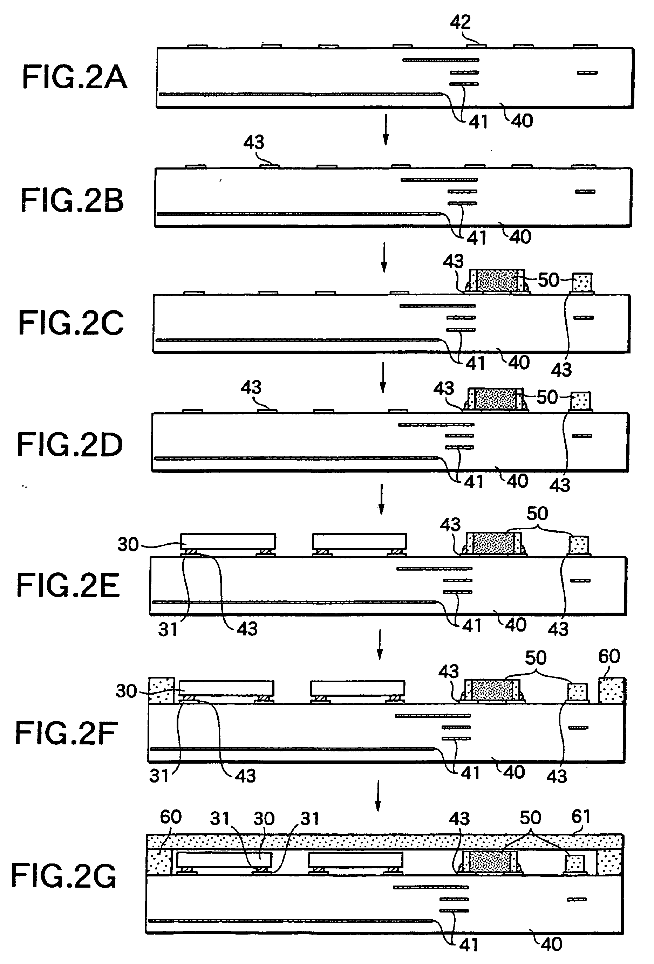

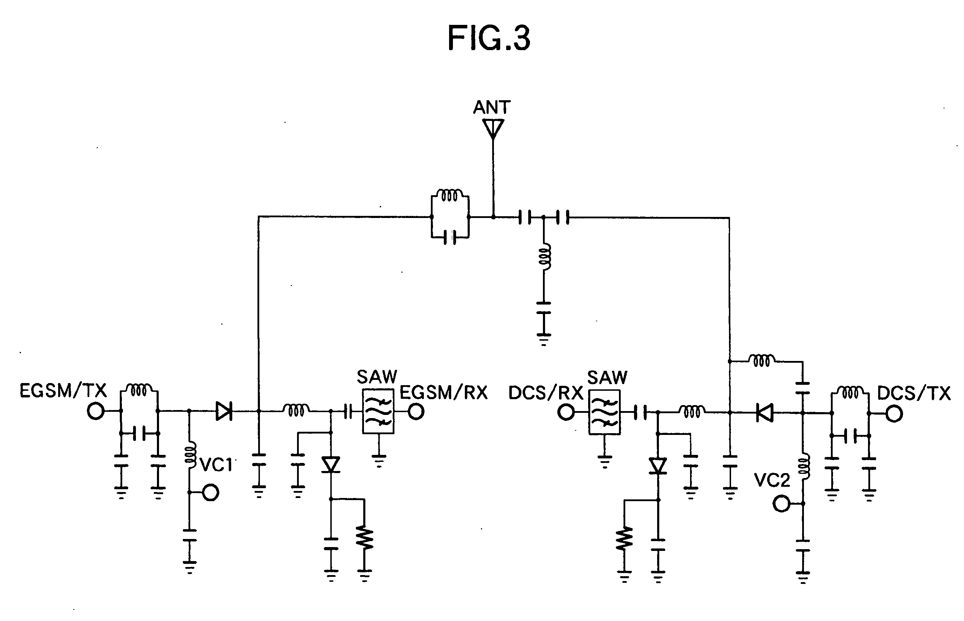

Fig. 1 is a first mode for carrying out the invention showing an accomplished condition of the radio frequency module parts including the surface acoustic wave elements. Figs. 2A to 2G show the production procedure thereof. Fig. 3 shows a circuit therefor.

At first, the first mode will be described sequentially in reference to the production processes as shown in Figs. 2A to 2G. In Fig. 2A, reference numeral 40 denotes the ceramic multi-layer substrate which was composed of 15 layers of inner electric conductors 41 having alumina glass composite ceramics as insulating layers. An external form was about 6 mm X 4 mm with thickness being 0.8 mm. The surface conductive layer 42 of the ceramic multi-layer substrate 40 was formed with a sintered silver conductor.

In the gold plating treatment procedure as shown in Fig. 2B, the ceramic multi-layer substrate 40 was plated with nickel of about 2 to 3 µm as a foundation plating on the surface conductive layer 42 (sintered silver conductor) thereof, followed by gold-plating to form mounting electrodes 43 having the gold film.

In the procedure of mounting the soldered parts in Fig. 2C, on the ceramic multi-layer substrate 40, the soldering paste was coated on the solder-connected portions of the mounting electrodes 43 which had been formed with the gold film, and the solder members 50 (the surface mounting elements to be soldered) composing inductance, capacitance, resistor, diode and others in the circuit of Fig. 3. Subsequently, the solder was fixed through the reflow furnace. Thus, the respective members 50 were fixed by soldering to the surface conductive layers 42 plated with the gold film, in short, the mounted electrodes 43.

Thereafter, in the cleaning procedure shown in Fig. 2D, the ceramic multi-layer substrate 40 having the solder members 50 mounted thereon was subjected to alkali medicine liquid cleaning or plasma cleaning (plasma etching).

In the flip mounting procedure shown in Fig. 2E where the SAW element was performed with gold-to-gold bonding, the SAW element was not the package member but the flip chip mounting type SAW element, i.e., the flip chip 30 being the bare chip as shown in Fig. 12. The flip chip 30 passed a similar process just like the package member and was formed with the gold stud bump 31 on the main surface provided with the ladder type electrodes for the SAW element (in short, this may be obtained by omitting the processes of mounting to the package and sealing of the latter half in the package member). The flip chip 30 was mounted by gold-to-gold bonding to the mounting electrodes 43 on the ceramic multi-layer substrate 40 in a manner of turning down the main surface provided with the ladder type electrodes for the SAW element (face-down-bonding).

By changing the diameter of the gold line and the forming conditions, the gold stud bump 31 maybe varied as to the diameter and may be within a proper range, and by changing the length of the gold line, the gold stud bump 31 may be varied as to the length and the gap between the mounting electrode 43 on the substrate 40 and the flip chip 30 may be set in a proper range. The face-down-bonding of the flip chip 30 was performed in a manner that the flip chip 30 was placed at a predetermined position as was turned down, and then the supersonic wave of 9 W was applied for 0.6 second on the side of the flip chip 30 while the load of 300 g was applied at the same time. Thus the gold stud bump 31 was bonded by way of the supersonic waves to the gold surface of the mounting electrode 43 on the side of substrate.

Incidentally, the shear strength of the flip chip 30 as the SAW element in case of changing the cleaning process to non-cleaning, alkali chemical cleaning, will be discussed later in reference to Table 1. The relation between the gold plated thickness of the mounting electrode 43 and the shear strength of the flip chip 30 as well as the solder member 50, will be discussed later in reference to Table 2. The diameter of the gold bump after mounting the flip chip 30 (after the supersonic wave bonding), the shear strength and the influences given to results of the heat impact test, will be discussed later in reference to Table 3. Further, influences of the gap spaces between the mounting electrode 43 and the flip chip 30 on the substrate 40 given to the horizontal pushing and results of the heat impact test, will be discussed later in reference to Table 4. When measuring in tables 1 to 4, the electronic microscope inspected the cross sections, diameters and interfaces of the gold bump when mounting the same.

After the flip chip 30 as the SAW element was mounted, as shown in Fig. 2F, the plate of square framed epoxy resin was bonded on the ceramic multi-layer substrate 40, said plate being hollowed out to become the resin side wall 60 for receiving the flip chip 30 as the SAW element and the solder member 50, and further as shown in Fig. 2G, the epoxy resin plate becoming the cover 61 was bonded by means of an adhesive, and was further bonded for 5 hours in vacuum to more strengthen the bonding.

Through the procedures shown in Fig. 2A to G, the ceramic multi-layer substrate 40 having the internal conductive layers 41 shown in Fig. 1 were mounted thereon with the flip chip 30 as the SAW element and the other solder members 50 as the surface mounting elements, wherein the solder members 50 were soldered on the ceramic multi-layer substrate 40, and the flip chip 30 having the gold bump 31 was face-down-bonded by way of gold-to-gold bonding (gold ball bond method) to the gold plated mounting electrode 43 of the ceramic multi-layer substrate 40, and further the flip chip 30 and the other solder members 50 were covered as sealed airtight by the side wall 60 of the resin and the resin cover 61 for covering the opening of this side wall fixed to the ceramic multi-layer substrate 40. Thus the radio frequency module parts sealed airtight were obtained. The radio frequency module parts had the external form of length and breadth 6 mm X 4 mm and height 1.5 mm.

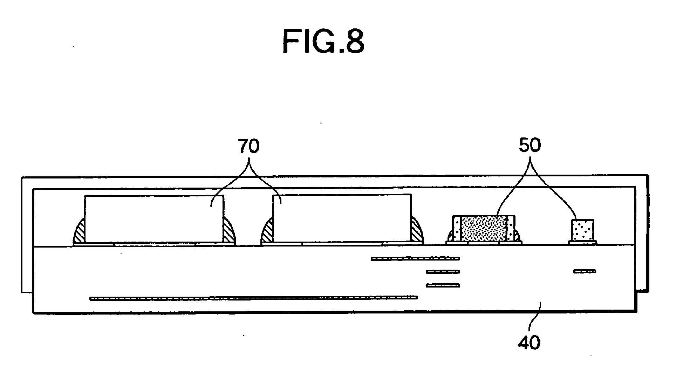

In the circuit shown in Fig. 3, the portions except the SAW element are already completed in the form of product as the module with a size about 6 mm X 4 mm likewise. The module of the same size may have the 2 SAW elements mounted thereon, from which it is seen that this maybe sufficiently miniaturized. Further, the module according to the present embodiment has a height of 1.5 mm. As shown in Fig. 8, when the SAW package member 70 is simply mounted on the conventional product (the module having the solder members 50 mounted on the ceramic multi-layer substrate 40), the height is about 2 mm. It is apparent that the height is sufficiently reduced in comparison with the conventional one as shown in Fig. 8. By the way, in Fig. 8, the same members as or corresponding to the members of Fig. 1 are denoted with the same reference numerals.

Fig. 4 shows the temperature characteristics when the flip chip of the SAW element is mounted on the ceramic multi-layer substrate as the present embodiment (dotted line), and when the flip chip is mounted likewise on the resin substrate (solid line) . It may be seen that the ceramic multi-layer substrate is less in change of frequency in company with the temperature change.

Table 1 shows the shear strength when the test samples were produced by changing the cleaning process to non-cleaning, alkali chemical liquid cleaning and plasma cleaning respectively. The diameter of the gold bump was 100 µm after mounting the flip chip 30, the gap distance between the mounted electrode 43 and the flip chip 30 on the substrate 40 was 20 µm, and the gold plated film of the mounted electrode 43 of the substrate side was 0.5 µm.

**[Table 1]**

| Table 1: Influences of the cleaningprocess to the shear strength. | |
|---|---|
| Cleaning ways | Shear strength |
| Non-cleaning | 350 |
| Chemical liquid cleaning | 400 |
| Plasma cleaning : 450W | |
| 1 min | 360 |
| 2 min | 420 |
| 3 min | 450 |
| 5 min | 460 |
| 8 min | 460 |
| 10 min | 360 |
| 15 min | 320 |

As is apparent from Table 1, in the case of non-cleaning, it is seen that the fixing strength is extremely weak. This sample was fixedly inserted in the buried resin, polished on the surface, and observed at the cross section by the electronic microscope, foreign matters like the flux were attached to the surface. It was considered that the foreign matters caused reduction of the shear strength. The medicine liquid cleaning was performed with alkali based cleaning liquid. In this case, the test sample was at a level of no particular problem for practical use. The plasma cleaning performed by spattering in argon plasma was resulted as follows. The output was 450 W constant and the time was a parameter. 1 minute is not yet sufficient for the required strength. In the time exceeding 10 minutes, the required strength again had come to be not obtained. In the time less than 1 minute, the surface was not activated, and in the time more than 10 minutes, the mounting electrode 43 was found to have injures at the gold surface layer. The preferred region was 2 minutes or more to 8 minutes or less.

Table 2 shows the shear strength when the test samples were produced by changing the gold plated thickness of the mounted electrode 43 on the substrate 40 in the region 0.05 µm to 7.0 µm with respect to a 1005 chip inductor (1 X 0.5 X 0.5 mm) as the flip chip 30 and the soldering member 50. In this case, the diameter of the gold bump was 100 µm after mounting the flip chip 30, the gap distance was 20 µm between the mounted electrode 43 and the flip chip 30 on the substrate 40, and the gap distance was 20 µm between the mounted electrode 43 and the 1005 chip inductor, and the plasma cleaning was for 5 minutes.

**[Table 2]**

| Table 2: Influences of the plated thickness to the shear strength of the SAW element and the solder mounting chip respectively. | | |
|---|---|---|
| Gold plated thickness (µm) | Shear strength of SAW (gf) | Shear strength of chip parts (gf) |
| 0.05 | 310 | 800 |
| 0.1 | 400 | 1200 |
| 0.3 | 420 | 1500 |
| 0.5 | 460 | 1600 |
| 1.0 | 470 | 1700 |
| 2.0 | 480 | 1600 |
| 3.0 | 470 | 1700 |
| 5.0 | 480 | 1700 |
| 7.0 | 480 | 800 |
| | | Peeling Occurred |

From the results as shown in Table 2, it was found out that in case the gold film, that is, the thickness of the gold plated layer was less than 0.1 µm, the strength was extremely low in the case of the gold-to-gold bonding and also in the case of the gold-to-solder bonding. There was no particular problem in case the thickness of gold plated layer exceeded 5 µm. However, in the case of the solder bonding, the shear strength was extremely lowed where friction was produced between the plated layer and the silver bed. This may be interpreted that a stress is concentrated to the interface at the time of fixing the solder. Therefore, the gold plated thickness as the gold film is preferably 0.1 µm or more and 5 µm or less, and more preferably in the region between 0.3 µm and 3 µm.

Table 3 shows the results measured as to the influence that the diameter of the gold bump gave to the shear strength and the heat impact test of the flip chip 30 regarding the samples which were made respectively by changing the diameters of the gold bump in the region between 30 µm to 200 µm when the flip chip 30 as the SAW element was face-down-bonded to the substrate 40.

**[Table 3]**

| Table 3: Influence that the diameter of the gold bump gives to the shear strength and the heat impact test result of the SAW element. | | |
|---|---|---|
| Diameter of gold bump (µm) | Shear strength of SAW (gf) | Failure in the heat impact test (among 100 pieces) |
| 30 | 290 | 12 |
| 50 | 400 | 1 |
| 70 | 450 | 0 |
| 100 | 460 | 0 |
| 120 | 460 | 0 |
| 150 | 470 | 1 |
| 200 | 470 | 8 |

Herein, the heat impact test was made for more clearing the conditions. The test conditions included -40°C at the low temperature side and 85°C at the high temperature side which were held for 30 minutes at 100 cycles respectively. The estimation was made by measuring the insertion loss of the SAW element. The one which was initially about 2 dB and came to 5 dB or more was decided as failure. The estimation was decided by the number of failure of 100 samples. The other measuring conditions included the gold plated film being 0.5 µm of the mounted electrode 43 of the substrate side, the gap being 20 µm between the mounting electrode 43 and the flip chip 30 on the substrate 40, and the plasma cleaning was 5 minutes.

From the results as shown in Table 3, it was found that as the gold bump diameter came to be below 50 µm, the strength remarkably decreased and the percent defective increased after receiving the heat impact. In case the gold bump diameter exceeded 150µm, the shear strength was sufficiently high, but the percent defective increased after receiving the heat impact. In this case, it was found that the SAW element had peeling produced so often at the electrode side thereof. This suggests that in case the gold bump becomes extremely thick, the stress of heat impact is concentrated to the SAW element side. Therefore, it is preferable that the gold bump is 50µm or more and 150 µm or less at the time of mounting, and more preferably in the range of 70 µm to 120 µm.

Table 4 shows the measured results as to the influence that the gap distance between the mounted electrode 43 and the flip chip 30 on the substrate 40 gave to the shear strength and the heat impact test result of the flip chip 30 by use of the samples prepared to have the gap varied in the region 3 µm to 70 µm between the mounting electrode 43 and the flip chip 30. The gold film of the mounting electrode 43 of the substrate side was 0.5 µm, the gold lump diameter was 100 µm, the plasma cleaning was for 5 minutes and the heat impact test at -40°C to 85°C was 100 cycles.

**[Table 4]**

| Table 4: Influence that the gap gives to the shear strength and the heat impact test result of the SAW element. | | |
|---|---|---|
| Gap distance (µm) | Shear strength of SAW (gf) | Failure in the heat impact test (among 100 pieces) |
| 3 | 450 | 15 |
| 5 | 440 | 2 |
| 10 | 450 | 0 |
| 20 | 460 | 0 |
| 30 | 460 | 0 |
| 50 | 410 | 0 |
| 70 | 340 | 0 |

In case the gap distance is less than 5 µm, the strength is sufficient, but the failure comes out so often at the heat impact test. In case the gap distance exceeds 50µm, there is no problem at the heat impact test, but the shear strength remarkably decreases. Therefore, it is preferable that the gap distance is 5µm or more and 50µm or less, and more preferably in the range 10 µm to 30µm.

According to the first embodiment, the following effects may be obtained.

(1) Regarding the radio frequency electronic circuit parts including the flip chip 30 as the ceramic multi-layer substrate 40 and the SAW element directly mounted thereon, by use of the resin side walls 60 and the resin cover 61, the SAW element may be sealed airtight, the influence of the solder member 50 when producing is eliminated, the production efficiency is heightened, the reliability for use is increased, the mounting efficiency at mounting may be increased, and further the product may be reduced in height.

Thus, with the radio frequency module parts being structured where the sides and upper part of mounting the module member are sealed airtight covered by the resin side walls 60 and the resin cover 61, (1) the problem for sealing airtight the SAW element may be solved

(2) With the face-down-bonding (flip chip mounting) being taken by way of gold-to-gold bonding of the flip chip 30 as the SAW element on a gold plated electrode of the ceramic multi-layer substrate 40, (2) the problem for giving durability against temperature change with the support method of giving no influence to the SAW element may be solved. Particularly, with the thickness of gold plating and the diameter of gold bump being made suitable in addition to the mounting of the flip chip by gold-to-gold bonding, the temperature change durability is made more preferable. Specifically, the gold plated film of the mounted electrode 43 formed on the ceramic multi-layer substrate 40 is set to be 0.1 µm or more and 5 µm or less, the distance between the flip chip 30 as the SAW element and the mounted electrode 43 is set to be 5 µm or more and 50 µm or less, the diameter of gold bump for gold-to-gold bonding when bonding is set to be 50 µm or more and 50 µm or less.

(3) In the manufacturing method, at least the member bonding portion of the surface conductive layer 42 of the member mounting ceramic multi-layer substrate 40 is gold-plated to form the mounting electrode 43, the members except at least one SAW element are mounted by soldering, the cleaning is performed, subsequently the flip chip 30 as the SAW element is flip-chip mounted to the ceramic multi-layer substrate 40 by way of gold-to-gold bonding though the resin material of the side walls 60 and the resin cover 61 are bonded with the adhesive. In this method, the solder members to be mounted by soldering may follow the conventional way. The gold plated surface is sufficiently wet and enough fixed. With this manufacturing method, (3) the problem for making compatible the soldering process and the SAW element mounting process may be solved. However, as the surface of the substrate is dirty with scatters of flux and the residues of solder after mounting with solder, it is difficult to mount the SAW element to the gold surface of the SAW element mounting portion. According to the present embodiment, the cleaning is performed to activate the gold surface so that no obstacle appears for mounting. The general medicine liquid cleaning activate the gold surface to an extent of allowing the SAW element to be mounted. However, the cleaning by way of the plasma etching is more preferred. In this case, it is required to take a condition of giving no damage to other mounting members. Further, the resin such as the side walls 60 and the cover 61 is bonded in vacuum so that dirt around the SAW and the attached matters may be eliminated.

(4) With the precedently described structure and production method being employed, (4) the problem for making flat the surface of module and reducing the height may be necessarily attained. As to the actual mounting of members, it is preferable to comply with various mounting machines. There is no problem, of course, if all parts are flat, and if the upper surface of module is flat 30% or more, it is good, and more preferably 50% or more.

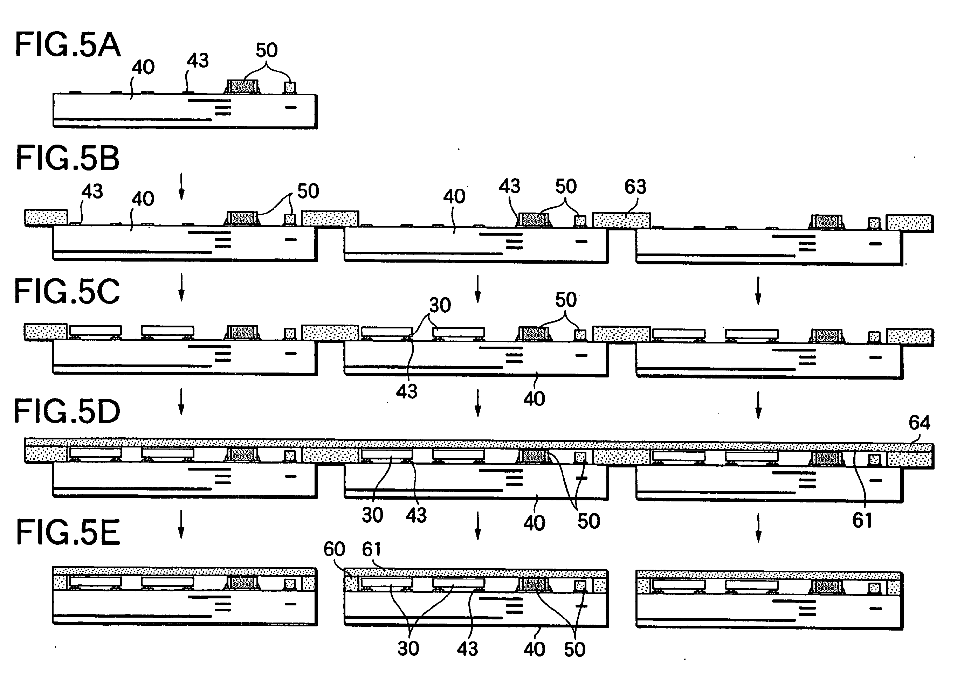

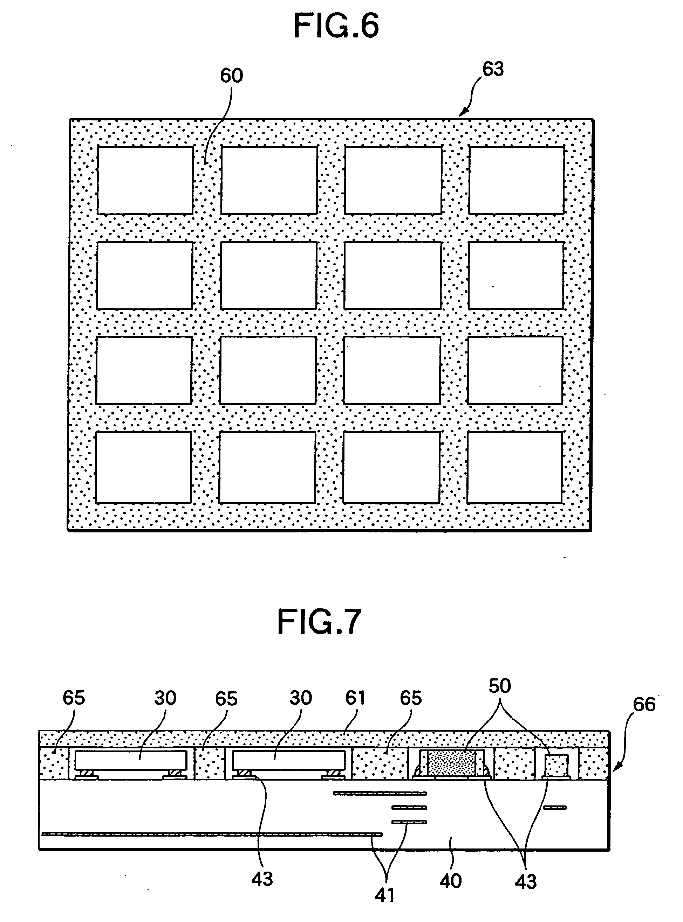

Figs. 5A to 5E show a second embodiment, showing that a plurality of pieces of the ceramic multi-layer substrates are treated in a lump. In this case, the processes are the same as the processes shown in Fig. 2A to 2D, from mounting of the solder member on each ceramic multi-layer substrate 40 to cleaning of the substrate as shown in Fig. 5A. Thereafter, as shown in Fig. 6, with preparation of a lattice like resin member 63 having a plurality of portions (preferably 10 or more) formed in one body as so many resin side walls 60, a plurality of ceramic multi-layer substrates 40 (preferably 10 or more) are bonded on the lattice like resin member 63 as shown in Fig. 5B. Subsequently, as shown in Fig. 5C, the flip chip 30 as the SAW element is face-down-bonded to a plurality of ceramic multi-layer substrates 40, and then as shown in Fig. 5D, a resin plate 64 having a plurality of covers 61 formed in one body is bonded as a lumped process. Finally, as shown in Fig. 5E, the resin member 63 and the resin plate 64 are cut to be divided as individual members each having one ceramic multi-layer substrates 40. By the way, in Figs. 5A to 5E, the same portions as or corresponding to the portions of Figs . 2A to 2G are denoted by use of the same reference numerals.

In the generally available mounting of the solder member 50, a metal mask is placed on the flat substrate 40, and the solder paste is print-coated, and the member 50 is arranged and the solder is fixed through the reflow furnace. Therefore, in case the resin member 63 as the side walls is bonded before the soldering process, the surface becomes uneven and the normal solder paste coating is difficult.

According to the second embodiment, in addition to the working effects of the first embodiment, a plurality of ceramic multi-layer substrates 40 may be treated in a lump at least in a certain part of the production processes base, thereby to considerably save labor, increase the production efficiency and accomplish the cost-down. Namely, (5) the problem for increasing the production efficiency by treating a plurality of ceramic multi-layer substrates board in a lump may be solved.

Fig. 7 is a third embodiment, showing that the SAW element is isolated from the other members. In this case, the resin member 66 forming the side walls 65 is not simply square, but has holes hollowed out for receiving therein the flip chip 30 as the SAW element and the solder member 50 individually. The resin member 66 is bonded on the ceramic multi-layer substrates 40, and the epoxy resin plate as the cover 61 is bonded by the adhesive. The other part of structure is the same as the first embodiment. Herein, the same or corresponding members are denoted by the same reference numerals.

According to the third embodiment, the resin side walls 65 may be also provided between the flip chip 30 as the SAW element and the solder members as the other mounting members. In this case, each member may be isolated from the other members . Therefore, even if contaminating matter is produced from the other mounting members in practical use, this will not deteriorate the property of the SAW element. Further, in this case, the structure of the resin side walls 65 and the cover 61 may be further preferably consolidated. The other working effects are the same as those of the first embodiment.

Having explained the invention in reference to the embodiments, it will be apparent to those skilled in the art that the invention may be modified in many ways within the scope of the claims without departing from the invention.

As has been described, according to the invention, the surface acoustic wave elements and other surface mounting elements are mounted on the ceramic multi-layer substrate, wherein the surface acoustic wave elements are flip chips which are face-down-bonded by way of gold-to-gold bonding to the gold coated electrodes of the ceramic multi-layer substrate, and at least the surface acoustic wave elements are covered as sealed airtight by the side walls fixed to the multi-layer ceramic substrate and the cover covering the opening of the side walls. Therefore, the SAWelementsmaybe kept airtight and the influence of the soldered surface mounting elements at the time of production is eliminated. Further, the productivity, the reliability for use and the mounting efficiency at the time of mounting may be increased, and further the height of the product may be reduced.

## Claims

1. A radio frequency module part comprising:
a ceramic multi-layer substrate (40);
surface acoustic wave elements and other surface mounting elements (50) mounted on said ceramic multi-layer substrate (40), said surface acoustic wave elements being flip chips (30) which are face-down-bonded by way of gold-to-gold bonding to gold-coated electrodes (43) of said ceramic multi-layer substrate (40);
**characterized in that** said radio frequency module part further comprises
a cover (61) which seals the surface acoustic wave elements and said other surface mounting elements in an airtight way, wherein side walls (60) separate from said cover (61) are fixed to said ceramic multi-layer substrate, and said cover (61) covers the opening of said side walls (60).

2. The radio frequency module part including surface acoustic wave elements as set forth in claim 1, wherein at least one of said other surface mounting elements is mounted on the ceramic multi-layer substrate by way of soldering.

3. The radio frequency module part including surface acoustic wave elements as set forth in claim 1 or 2, wherein said surface acoustic wave elements are isolated from said other surface mounting elements by the side walls and the cover.

4. The radio frequency module part including surface acoustic wave elements as set forth in claim 1 or 2, wherein the area of a portion surrounded by the side walls and covered by the cover is 30 % or more and 100 % or less of said ceramic multi-layer substrate.

5. The radio frequency module part including surface acoustic wave elements as set forth in claim 1, or 2, wherein the gold film of the gold plated electrodes of the ceramic multi-layer substrate is between 0.1 µm or more and 5 µm or less, the space between the surface acoustic wave elements and the gold plated electrodes is between 5 µm or more and 50 µm or less, and the diameter after bonding the gold bumps for the gold-to-gold bonding is between 50 µm or more and 150 µm or less.

6. A manufacturing method of radio frequency module parts including surface acoustic wave elements, **characterized by** comprising the steps of:
plating a gold plate to at least portions of bonding parts of conductive surfaces of a ceramic multi-layer substrate (40);
mounting by soldering, after said plating procedure, at least one surface mounting element (50) other than the surface acoustic wave elements to said ceramic multi-layer substrate (40);
cleaning the multi-layer ceramic substrate (40) after said soldering;
mounting, after said cleaning procedure, flip chips (30) of the surface acoustic wave elements via face-down-bonding to the ceramic multi-layer substrate (40) by way of gold-to-gold bonding;
bonding members becoming side walls (60) to the ceramic multi-layer substrate (40); and
sealing airtight a space surrounded by the members becoming the side walls (60) and a member becoming a cover (61) by attaching the member becoming the cover (61) after mounting the surface acoustic wave elements and forming the side walls (60).

7. The manufacturing method of the radio frequency module parts including the surface acoustic wave elements as set forth in claim 6, wherein said side wall forming procedure is carried out by bonding said side wall forming members in common to plural pieces of the ceramic multi-layer substrates, and at least parts of the following steps thereafter are carried out in a lump, and the members finally becoming the said side walls are cut per each of ceramic multi-layer substrates.

8. The manufacturing method of the radio frequency module parts including the surface acoustic wave elements as set forth in claim 6 or 7, wherein the cleaning procedure is for cleaning said ceramic multi-layer substrate by way of a plasma etching.

## Patentansprüche

1. Radiofrequenzmodul umfassend:
ein Mehrlagen-Keramiksubstrat (40);
Oberflächenwellen-Bauelemente und weitere oberflächenmontierte Bauelemente (50), die auf dem Mehrlagen-Keramiksubstrat (40) befestigt sind, wobei die Oberflächenwellen-Bauelemente Flip-Chips (30) umfassen, die anhand einer Gold-Gold Verbindung mit der Vorderseite nach unten mit vergoldeten Elektroden (43) des Mehrlagen-Keramiksubstrats (40) verbunden sind;
**dadurch gekennzeichnet, dass** das Radiofrequenzmodul des Weiteren umfasst:
eine Abdeckung (61), die die Oberflächenwellen-Bauelemente (50) und die weiteren oberflächenmontierte Bauelemente luftdicht verschließt, wobei Seitenwände (60) getrennt von der Abdeckung (61) an das Mehrlagen-Keramiksubstrat (40) befestigt sind, und die Abdeckung (61) die Öffnung der Seitenwände (60) bedeckt.

2. Radiofrequenzmodul mit Oberflächenwellen-Bauelementen gemäß Anspruch 1, wobei zumindest eines der weiteren oberflächenmontierte Bauelemente anhand einer Lötung auf dem Mehrlagen-Keramiksubstrat befestigt ist.

3. Radiofrequenzmodul mit Oberflächenwellen-Bauelementen gemäß Anspruch 1 oder 2, wobei die Oberflächenwellen-Bauelemente durch die Seitenwände und die Abdeckung getrennt von den weiteren oberflächenmontierte Bauelementen befestigt sind.

4. Radiofrequenzmodul mit Oberflächenwellen-Bauelementen gemäß Anspruch 1 oder 2, wobei die Fläche eines Bereiches, der von den Seitenwänden umgeben und von der Abdeckung bedeckt ist, 30% oder mehr und 100% oder weniger des Mehrlagen-Keramiksubstrats beträgt.

5. Radiofrequenzmodul mit Oberflächenwellen-Bauelementen gemäß Anspruch 1 oder 2, wobei die Goldschicht der vergoldeten Elektroden des Mehrlagen-Keramiksubstrats zwischen 0,1 µm oder mehr und 5 µm oder weniger beträgt, der Abstand zwischen den Oberflächenwellen-Bauelementen und den vergoldeten Elektroden zwischen 5 µm oder mehr und 50 µm oder weniger beträgt, und der Durchmesser nach dem Verbinden der Goldhöcker für die Gold-Gold Verbindung zwischen 50 µm oder mehr und 150 µm oder weniger beträgt.

6. Fertigungsverfahren für Oberflächenwellen-Bauelemente umfassende Radiofrequenzmodule **gekennzeichnet durch** die Schritte:
Beschichten von zumindest Bereichen der Verbindungsbauelemente auf einer leitfähigen Oberfläche eines Mehrlagen-Keramiksubstrats (40) mit einem Goldüberzug;
Nach dem Beschichtungsverfahren, Befestigen von zumindest einem weiteren oberflächenmontierte Bauelement (50) als den Oberflächenwellen-Bauelementen an das Mehrlagen-Keramiksubstrat (40) mithilfe eines Lötvorgangs;
Reinigen des Mehrlagen-Keramiksubstrats (40) nach dem Lötvorgang;
Nach dem Reinigungsverfahren, Befestigen von Flip-Chips (30) als Oberflächenwellen-Bauelemente, die anhand einer Gold-Gold Verbindung mit der Vorderseite nach unten mit dem Mehrlagen-Keramiksubstrat (40) verbunden werden;
Bilden von Seitenwänden (60) aus Verbindungselementen auf dem Mehrlagen-Keramiksubstrat (40); und
Luftdichtes Verschließen einer Aussparung, die von den die Seitenwände (60) bildenden Elementen und von einem eine Abdeckung (61) bildenden Element umgeben ist, **durch** Befestigen des die Abdeckung (61) bildenden Elements nach dem Befestigen der Oberflächenwellen-Bauelemente und Bilden der Seitenwände (60).

7. Fertigungsverfahren für Oberflächenwellen-Bauelemente umfassende Radiofrequenzmodule nach Anspruch 6, wobei das Verfahren zum Bilden der Seitenwände durch gemeinsames Verbinden der Seitenwand bildenden Elemente mit mehreren Teilen der Mehrlagen-Keramiksubstrate ausgeführt wird, und wobei zumindest Bereiche der nachfolgenden Schritte danach auf einmal ausgeführt werden, und die Elemente, die letztendlich die Seitenwände bilden, für jedes Mehrlagen-Keramiksubstrat geschnitten werden.

8. Fertigungsverfahren für Oberflächenwellen-Bauelemente umfassende Radiofrequenzmodule nach Anspruch 6 oder 7, wobei das Reinigungsverfahren dem Reinigen des Mehrlagen-Keramiksubstrats durch Plasmaätzen dient.

## Revendications

1. Elément de module radiofréquence comprenant :
un substrat multicouches en céramique (40) ;
des éléments d'onde acoustique de surface et d'autres éléments de montage en surface (50) montés sur ledit substrat multicouches en céramique (40), lesdits éléments d'onde acoustique de surface étant des puces retournées (30) qui sont liées face vers le bas au moyen d'une liaison or-or à des électrodes plaquées d'or (43) dudit substrat multicouches en céramique (40) ;
**caractérisé en ce que** ledit élément de module radiofréquence comprend en outre
un couvercle (61) qui ferme les éléments d'onde acoustique de surface et lesdits autres éléments de montage en surface de manière étanche à l'air, des parois latérales (60) séparées dudit couvercle (61) étant fixées audit substrat multicouches en céramique, et ledit couvercle (61) couvrant l'ouverture desdites parois latérales (60).

2. Elément de module radiofréquence comprenant des éléments d'onde acoustique de surface selon la revendication 1, dans lequel au moins l'un desdits autres éléments de montage en surface est monté sur le substrat multicouches en céramique par soudage.

3. Elément de module radiofréquence comprenant des éléments d'onde acoustique de surface selon la revendication 1 ou 2, dans lequel lesdits éléments d'onde acoustique de surface sont isolés desdits autres éléments de montage en surface par les parois latérales et le couvercle.

4. Elément de module radiofréquence comprenant des éléments d'onde acoustique de surface selon la revendication 1 ou 2, dans lequel la zone d'une partie entourée par les parois latérales et couverte par le couvercle correspond à 30 % ou plus et 100 % ou moins dudit substrat multicouches en céramique.

5. Elément de module radiofréquence comprenant des éléments d'onde acoustique de surface selon la revendication 1 ou 2, dans lequel le film d'or des électrodes plaquées d'or du substrat multicouches en céramique est compris entre 0,1 µm ou plus et 5 µm ou moins, l'espace entre les éléments d'onde acoustique de surface et les électrodes plaquées d'or est compris entre 5 µm ou plus et 50 µm ou moins, et le diamètre, après la liaison des cordons de soudure en or pour la liaison or-or, est compris entre 50 µm ou plus et 150 µm ou moins.

6. Procédé de fabrication d'éléments de module radiofréquence comprenant des éléments d'onde acoustique de surface, **caractérisé par le fait qu'**il comprend les étapes consistant à :
plaquer une plaque d'or sur au moins des parties d'éléments de liaison de surfaces conductrices d'un substrat multicouches en céramique (40) ;
monter par soudage, après ladite procédure de placage, au moins un élément de montage en surface (50) autre que les éléments d'onde acoustique de surface sur ledit substrat multicouches en céramique (40) ;
nettoyer le substrat multicouches en céramique (40) après ledit soudage ;
monter, après ladite procédure de nettoyage, des puces retournées (30) des éléments d'onde acoustique de surface, par liaison face vers le bas, sur le substrat multicouches en céramique (40) au moyen d'une liaison or-or ;
lier des éléments devenant des parois latérales (60) sur le substrat multicouches en céramique (40) ; et
fermer de manière étanche à l'air un espace entouré par les éléments devenant les parois latérales (60) et un élément devenant un couvercle (61) en fixant l'élément devenant le couvercle (61) après le montage des éléments d'onde acoustique de surface et la formation des parois latérales (60).

7. Procédé de fabrication d'éléments de module radiofréquence comprenant des éléments d'onde acoustique de surface selon la revendication 6, dans lequel ladite procédure de formation de paroi latérale est effectuée en liant lesdits éléments de formation de paroi latérale conjointement avec plusieurs pièces de substrats multicouches en céramique, et au moins des parties des étapes suivantes sont effectuées dans un bloc, et les éléments devenant finalement lesdites parois latérales sont coupés pour chacun des substrats multicouches en céramique.

8. Procédé de fabrication d'éléments de module radiofréquence comprenant des éléments d'onde acoustique de surface selon la revendication 6 ou 7, dans lequel la procédure de nettoyage est destinée à nettoyer ledit substrat multicouches en céramique par gravure par plasma.
